# EUROPÄISCHE PATENTSCHRIFT

(11) **EP 1 950 579 B1**
(45) Veröffentlichungstag und Bekanntmachung des Hinweises auf die Patenterteilung: **22.09.2010**
(21) Anmeldenummer: 08001277.6
(22) Anmeldetag: 24.01.2008
(51) Int. Cl.: G01R 33/30, B01L 3/00

(54) **Kappe für ein NMR-Probenröhrchen mit innen liegender Dichtlippe**
Cap for a NMR sample tube with interior sealing lip
Chaperon pour un petit tube à essai RMN doté d'une lèvre d'étanchéité intérieure

(30) Priorität: 27.01.2007 DE 102007004227
(43) Veröffentlichungstag der Anmeldung: 30.07.2008
(73) Patentinhaber: Bruker BioSpin AG, 8117 Fällanden (CH)
(72) Erfinder: Himmelsbach, Kurt, 8320 Fehraltdorf (ZH) (CH); Sestito, Franco, 8408 Winterthur (CH); Grossniklaus, Beat, 8173 Neerach (ZH) (CH)
(74) Vertreter: Kohler Schmid Möbus

(56) Entgegenhaltungen:
- EP-A- 0 454 493
- EP-A- 1 066 881
- DE-A1- 10 343 405
- JP-A- 61 023 952
- JP-A- 2002 058 663

## Beschreibung

Die Erfindung betrifft eine Kappe für ein NMR-Probenröhrchen, mit einer Innenbohrung für die Aufnahme eines offenen Endes eines NMR-Probenröhrchens,
wobei die Innenbohrung eine Wand aufweist, im Wesentlichen kreiszyl inderförmig ausgebildet ist und eine Verengung zum Abdichten eines aufgenommenen NMR-Probenröhrchens gegen die Kappe entlang des Außenumfangs des NMR-Probenröhrchens aufweist,
wobei die Verengung als eine über den gesamten Außenumfang umlaufende, innen liegende, elastisch verformbare Dichtlippe ausgebildet ist.

Eine solche Kappe ist bekannt aus der EP 1 066 881 A2.

Die Kernspinresonanz(NMR-)Spektroskopie ist eine wirkungsvolle Methode zur Strukturanalyse von chemischen Verbindungen. Zu untersuchende Proben werden in einem starken statischen Magnetfeld elektromagnetischen Pulsen ausgesetzt. Die elektromagnetische Antwort der Probe wird vermessen.

Proben werden für einige Messverfahren in Probenröhrchen gefüllt, wobei die Probe die eigentliche Messsubstanz sowie ein Lösungsmittel (NMR-Lösungsmittel) umfasst. Die Probenröhrchen sind in der Regel einseitig offene, runde Glas- oder Kunststoffröhrchen mit einem Außendurchmesser von 3-5 mm. Die Handhabung, insbesondere das Befüllen der Probenröhrchen kann durch aufgesetzte Kappen, beispielsweise mit einem trichterförmigen Zugangskanal, erleichtert werden. Während der NMR-Messung ist auf ein Probenröhrchen ebenfalls in der Regel eine Kappe (Verschlusskappe) aufgesetzt, um ein Entweichen der Probe zu verhindern, insbesondere wenn die Probe während der NMR-Messung schnell rotiert wird.

Es ist bekannt, die Probenröhrchen mittels eines zapfenartigen Pfropfens, der in das Probenröhrchen eingeführt wird, zu verschließen. Durch den Pfropfen werden jedoch Zugkräfte auf die Wand des Probenröhrchens eingebracht, die insbesondere im Falle eines Probenröhrchens aus Glas leicht zu einer Beschädigung des Probenröhrchens führen können.

Eine aus der DE 103 43 405 bekannte Kappe für ein NMR-Probenröhrchen wird über das offene Ende eines Probenröhrchens geschoben. Die aus Kunststoff gefertigte Kappe weist an einer Innenbohrung, in der das NMR-Probenröhrchen angeordnet ist, einen Presssitz auf. Der Presssitz umfasst eine kreiszylindermantelförmige Anlagefläche, die im entspannten Zustand einen geringfügig kleineren Innendurchmesser aufweist als der Außendurchmesser des NMR-Probenröhrchens beträgt. Der Presssitz erstreckt sich in axialer Richtung typischerweise über einige Millimeter. Bei gehaltenem Probenröhrchen wird die Kappe am Presssitz elastisch gedehnt, und die gesamte Anlagefläche liegt am Außenumfang des Probenröhrchens an. Dadurch wird eine gas- und flüssigkeitsdichte Abdichtung des Probenröhrchens gegen die Kappe erreicht.

Nachteilig bei diesem Stand der Technik ist es, dass die Anlagefläche und die Außenwand des Probenröhrchens mit sehr engen Toleranzen gefertigt und aufeinander abgestimmt sein müssen, um eine gute Abdichtung zu erzielen. Aufgrund der großflächigen Anlage des Presssitz am Probenröhrchen kann eine relativ große Kraft auf das Probenröhrchen einwirken, so dass dieses leicht zerbrechen kann.

Eine Möglichkeit, den Krafteintrag auf das Probenröhrchen zu reduzieren und die Fertigungstoleranzen zu vergrößern, besteht in der Verwendung eines elastisch relativ weichen Kappenmaterials, wie Polypropylen. Allerdings weisen weiche Kappenmaterialen in der Regel eine weniger gute Resistenz gegenüber vielen NMR-Lösungsmitteln auf, was die Einsatzmöglichkeiten beschränkt.

Die EP 1 066 881 A2 beschreibt einen Sammelvorrichtung mit einem Probencontainer und einer abnehmbaren Kappe. An der Innenseite der Kappe ist eine Dichtlippe ausgebildet, mit dem die Kappe am Probencontainer anliegt. Die Kappe weist einen im Wesentlichen einheitlichen Außendurchmesser auf, und die Dichtlippe ist als an der Innenwand aufsitzender Wulst ausgebildet.

Die JP 2002 058663 A zeigt eine per Hand aufsetzbare Kappe für einen Vakuum-Probencontainer. Der Probencontainer wird mit dem unteren Rand eines elastischen Halsstücks geklemmt und mit einem Stopfen abgedichtet.

Die JP 61 023952 beschreibt eine Turbine für ein NMR-Probenröhrchen. An der Innenbohrung der Turbine sind zwei Dichtringe eingesetzt.

Die EP 0 454 493 A2 beschreibt einen ein- und wieder ausführbaren Verschluss für ein Probenröhrchen. Auf einer Innenseite, die außen am Röhrchen angreift, ist eine Versiegelungsschicht aufgebracht. Das Probenröhrchen wird mit einem innen liegenden Stopfen abgedichtet.

### Aufgabe der Erfindung

Es ist daher die Aufgabe der vorliegenden Erfindung, eine Kappe für ein NMR-Probenröhrchen vorzustellen, welche eine gute Abdichtung zwischen der Kappe und dem NMR-Probenröhrchen bewirken kann und aus einer großen Anzahl von Materialien, insbesondere Materialien mit guter chemischer Resistenz gegenüber NMR-Lösungsmitteln, hergestellt werden kann.

### Kurze Beschreibung der Erfindung

Diese Aufgabe wird gelöst durch eine Kappe der eingangs genannten Art, die dadurch gekennzeichnet ist, dass im entspannten Zustand der Kappe, in welchem kein NMR-Probenröhrchen in die Innenbohrung eingeführt ist, auf der radial außen liegenden Seite der Wand eine Aussparung vorhanden ist, deren Form der radial innen liegenden Seite der Dichtlippe entspricht, so dass die Wand der Kappe im gesamten Bereich der Dichtlippe und in der Umgebung der Dichtlippe eine einheitliche, konstante Wandstärke aufweist.

Die Innenkontur der erfindungsgemäßen Kappe ist so ausgebildet, dass mindestens eine Dichtlippe eine definierte Verengung bildet, welche ein eingeführtes Probenröhrchen dicht umfassen kann und mit ausreichendem Druck die Kappe auf dem Außenumfang des Probenröhrchens fixiert. Mit der Dichtlippe wird dann eine flüssigkeits- und gasdichte Abdichtung zwischen Kappe und Probenröhrchen erreicht.

Mit Hilfe der Dichtlippe wird der Dichtungsdruck auf eine definierte, gegenüber dem Stand der Technik stark verkleinerte Zone im Material der Kappe (in der Regel Kunststoff) beschränkt. Die Krafteinwirkung auf das Probenröhrchen wird insgesamt reduziert. Dadurch ist es einfacher, auch bei elastisch relativ harten Materialien eine genügende Elastizität, etwa zum Ausgleich von Fertigungstoleranzen, bei beschränkten Kräften auf das Probenröhrchen zu erreichen. Das Probenröhrchen, welches in der Regel aus Glas gefertigt ist, wird mechanisch weniger stark beansprucht, und die Bruchgefahr ist verringert.

Erfindungsgemäß ist vorgesehen, dass die Kappe im entspannten Zustand im Bereich der Dichtlippe und in einer Umgebung der Dichtlippe eine einheitliche, konstante Wandstärke aufweist. Dies führt lokal zu einer Art Wellenform der Wand der Kappe, ähnlich eines Balges. Diese Geometrie erleichtert eine elastische Verformung der Kappenwand im Bereich der Dichtlippe und reduziert so den Krafteintrag in ein gehaltenes Probenröhrchen. Wirken radiale Kräfte auf die Dichtlippe nach außen (Aufspreizen der Dichtlippe), so kann das Material der Dichtlippe leicht radial nach außen ausweichen. Dabei kommt es auch zu einer elastischen axialen Verschiebung von Wandmaterial. Die Kraft wird im Material also teilweise umgelenkt. Die Dehnkräfte beschränken sich im Wesentlichen auf die räumliche Ausdehnung der Dichtlippe selbst. Die obige Geometrie vereinfacht auch die Herstellung der Kappe im Spritzgussverfahren, wo eine Zwangsentformung notwendig ist.

Durch die Erfindung wird die bisherige Beschränkung des Kappenmaterials auf relativ weiche Kunststoffe aufgehoben. Auch relativ harte Kunststoffe, insbesondere solche mit guter chemischer Resistenz gegenüber NMR-Lösungsmitteln, werden als Kappenmaterial zugänglich.

Die erfindungsgemäße Dichtlippe ist typischerweise so ausgebildet, dass sie sich zum Inneren der Innenbohrung hin (d.h. radial nach innen hin) in ihrem Querschnitt verjüngt. Dadurch wird der Kontaktbereich zwischen Kappe und Probenröhrchen auf einfache Weise verringert. Die Dichtlippe ist so ausgelegt, dass beim Einklemmen eines Probenröhrchens die Verformung der Dichtlippe (bzw. der Kappe im Bereich und der Umgebung der Dichtlippe) im elastischen Bereich bleibt. Im geklemmten Zustand liegt die Dichtlippe typischerweise über 0,5 mm oder weniger, bevorzugt 0,3 mm oder weniger, in axialer Richtung am NMR-Probenröhrchen an. Die Innenbohrung ist im Wesentlichen kreiszylinderförmig ausgebildet; ein kreisrunder Querschnitt bei NMR-Probenröhrchen ist verbreitet und bewährt.

### Bevorzugte Ausführungsformen der Erfindung

Besonders bevorzugt ist eine Ausführungsform einer erfindungsgemäßen Kappe, bei der die Dichtlippe im entspannten Zustand auf der radial nach innen gewandten Seite einen abgerundeten Querschnitt aufweist. Der abgerundete Querschnitt vereinfacht das Einführen des NMR-Probenröhrchens bei geringer Verschleißanfälligkeit und gestattet eine kleine Kontaktfläche (insbesondere mit kleiner Ausdehnung in axialer Richtung) zwischen Kappe und Probenröhrchen.

Eine alternative, bevorzugte Ausführungsform sieht vor, dass die Dichtlippe im entspannten Zustand auf der radial nach innen gewandten Seite einen spitz zulaufenden Querschnitt aufweist. Auch damit kann eine kleine Kontaktfläche (insbesondere mit kleiner Ausdehnung in axialer Richtung) zwischen Kappe und Probenröhrchen erreicht werden.

Besonders bevorzugt ist auch eine Ausführungsform der erfindungsgemäßen Kappe, bei der die Innenbohrung einen Kontaktring zum Halten des NMR-Probenröhrchens an dessen Außenumfang aufweist, wobei der Kontaktring von der Dichtlippe verschieden ist. Der Kontaktring ist dazu ausgebildet, ein gehaltenes Probenröhrchen zusätzlich zur Dichtlippe zu fixieren und gegen Verkippung relativ zur Kappe zu sichern. Der Kontaktring kann dabei einzelne, punktuell oder abschnittweise anliegende Kontaktelemente, oder auch einen umlaufenden ringförmigen Kontaktbereich zum Probenröhrchen ausbilden.

Bevorzugt ist eine Weiterbildung dieser Ausführungsform, bei der der Kontaktring näher an einer Einführöffnung für das NMR-Probenröhrchen liegt als die Dichtlippe. Der von der Dichtlippe begrenzte obere Bereich der Innenbohrung, in dem beim Einführen des Probenröhrchens im Falle einer Verschlusskappe Gas komprimiert wird, ist dann besonders klein, und die Gegenkraft beim Einführen entsprechend gering.

Eine andere Weiterbildung der obigen Ausführungsform sieht vor, dass der Kontaktring von mehreren, separaten Segmenten gebildet wird. Jedes Segment liegt dann einzeln am Probenröhrchen an. Eine solche Kappe ist besonders einfach zu montieren.

Bei einer alternativen Weiterbildung ist der Kontaktring als weitere, innen liegende Dichtlippe ausgebildet ist. Dadurch kann die Dichtsicherheit erhöht werden, und es wird eine mechanisch besonders stabile, saubere Zweipunktanlage erreicht.

Bevorzugt ist auch eine Ausführungsform der erfindungsgemäßen Kappe, bei der die Kappe an ihrem Außenumfang eine Nut für den Eingriff eines Probengreifers aufweist. Dadurch wird die Kappe besonders gut handhabbar, insbesondere für einen automatischen Probengreifer. Die Nut ist bevorzugt umlaufend, braucht es aber nicht zu sein. Es können auch mehrere Nuten zur Gewichtsersparnis oder zum Eingriff auf mehreren Ebenen vorgesehen sein.

Eine Weiterbildung dieser Ausführungsform sieht vor, dass die Nut derart ausgebildet ist, dass wenigstens drei, insbesondere vier, Greiffinger des Probengreifers in die Nut eingreifen können, so dass die Greiffinger auf zwei Außenkanten der Nut drücken können. Der Probengreifer kann insbesondere ausgebildet sein wie in der DE 103 43 405 A1 als Greifvorrichtung eines NMR-Spektrometers beschrieben. Damit ist die Kappe besonders gut für die Handhabung durch einen greiffingerbasierten Probengreifer geeignet.

Bevorzugt ist es weiterhin in einer Ausführungsform, wenn die Kappe im Wesentlichen rotationssymmetrisch aufgebaut ist. Die Rotationssymmetrie der Kappe vereinfacht die Orientierung von Kappe samt Probenröhrchen in der Probenverwaltung und beim Beladen eines NMR-Spektrometers.

Bevorzugt ist weiterhin eine Ausführungsform, bei der die Kappe einen Zugangskanal zur Innenbohrung aufweist, der in einem oberen Bereich jenseits der Dichtlippe, der einer Einführöffnung für das NMR-Probenröhrchen abgewandt ist, in der Innenbohrung mündet. Durch den Zugangskanal kann eine Probe in ein gehaltenes Probenröhrchen eingefüllt werden, etwa mit einer Injektionsnadel.

Eine alternative, ebenfalls bevorzugte Ausführungsform sieht vor, dass die Kappe die Innenbohrung in einem oberen Bereich jenseits der Dichtlippe, der einer Einführöffnung für das NMR-Probenröhrchen abgewandt ist, vollständig verschließt. Eine solche Verschlusskappe wird in der Regel für den Verschluss eines Probenröhrchens während einer NMR-Messung benötigt, insbesondere wenn das Probenröhrchen während der Messung rotiert wird, etwa bei magic angle spinning (=MAS)-Messungen.

Besonders bevorzugt ist eine Ausführungsform, bei der die Kappe aus Kunststoff gefertigt ist. Bevorzugt sind elastisch relativ harte Kunststoffe, die eine hohe chemische Resistenz gegenüber gängigen NMR-Lösungsmitteln, insbesondere Chloroform, aufweisen. Ein besonders bevorzugter, elastisch relativ harter Kunststofftyp ist dabei ORGALLOY LE 6000.

In den Rahmen der vorliegenden Erfindung fällt auch eine NMR-Probenanordnung, umfassend eine Kappe und ein NMR-Probenröhrchen, auf welches die Kappe aufgesetzt werden kann, dadurch gekennzeichnet, dass die Kappe erfindungsgemäß ausgebildet ist wie oben beschrieben. Durch die Dichtlippe wird eine flüssigkeits- und gasdichte gegenseitige Abdichtung erreicht.

Weitere Vorteile der Erfindung ergeben sich aus der Beschreibung und den Zeichnungen. Die gezeigten und beschriebenen Ausführungsformen sind nicht als abschließende Aufzählung zu verstehen, sondern haben vielmehr beispielhaften Charakter für die Schilderung der Erfindung.

### Zeichnung und detaillierte Beschreibung der Erfindung

Die Erfindung ist in der Zeichnung näher dargestellt und erläutert. Es zeigen:
- Fig. 1: eine schematische Schrägansicht einer erfindungsgemäßen Kappe gemäß einer ersten Ausführungsform;
- Fig. 2: einen schematischen Querschnitt durch die erfindungsgemäße Kappe von Fig. 1;
- Fig. 3: eine Detailansicht der Dichtlippe aus Fig. 2;
- Fig. 4: eine Detailansicht einer Dichtlippe ähnlich Fig. 3 gemäß einer zweiten Ausführungsform einer erfindungsgemäßen Kappe, mit spitz zulaufender Dichtlippe;
- Fig. 5: eine schematische Querschnittsansicht durch eine erfindungsgemäße Probenanordnung mit einer erfindungsgemäßen Kappe und einem darin gehaltenen Probenröhrchen.

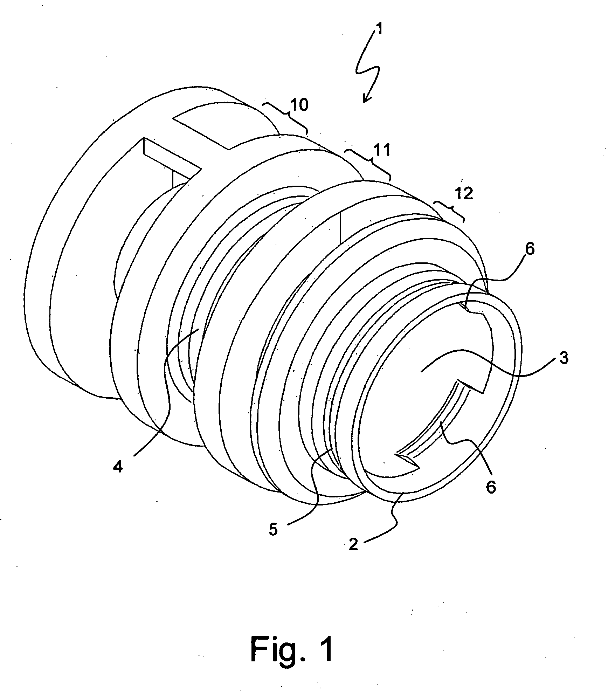

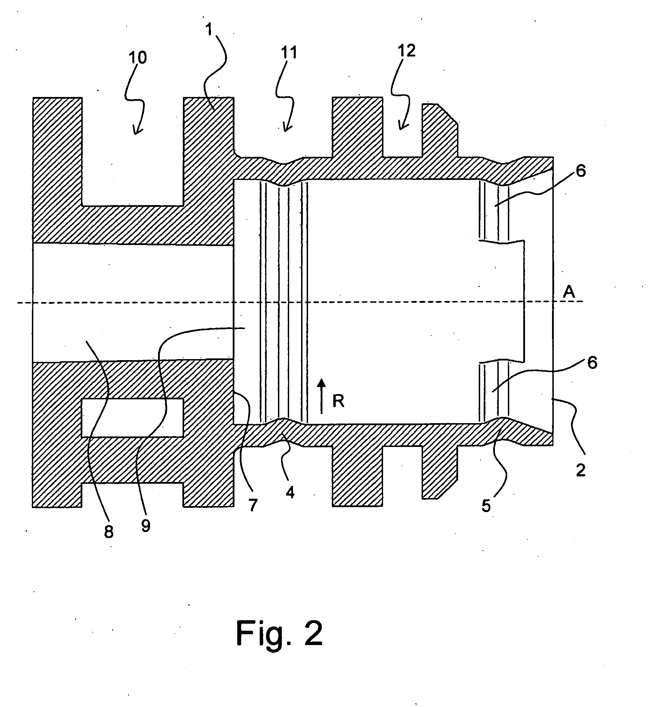

Die **Figuren 1** **und** **2** zeigen eine erste Ausführungsform einer erfindungsgemäße Kappe 1. Die im Wesentlichen rotationssymmetrische Kappe 1 weist eine Einführöffnung 2 auf, durch die ein Probenröhrchen (in Fig. 1, 2 nicht dargestellt) in eine Innenbohrung 3 der Kappe 1 eingeführt werden kann.

Die Innenbohrung 3 weist eine Verengung, nämlich eine umlaufende Dichtlippe 4 auf. Die Dichtlippe 4 ist in ihrem radial innersten Bereich (d.h. im am nächsten zur Rotationsachse A gelegenen Bereich) abgerundet. Die Dichtlippe 4 verjüngt sich dabei radial nach innen hin (in Pfeilrichtung R).

Die Innenbohrung 3 weist eine weitere Verengung, nämlich einen Kontaktring 5 auf. Der Kontaktring 5 wird gebildet durch mehrere, separate Segmente 6, die - ähnlich wie die Dichtlippe 4 - radial nach innen ragen und sich dabei nach innen hin verjüngen.

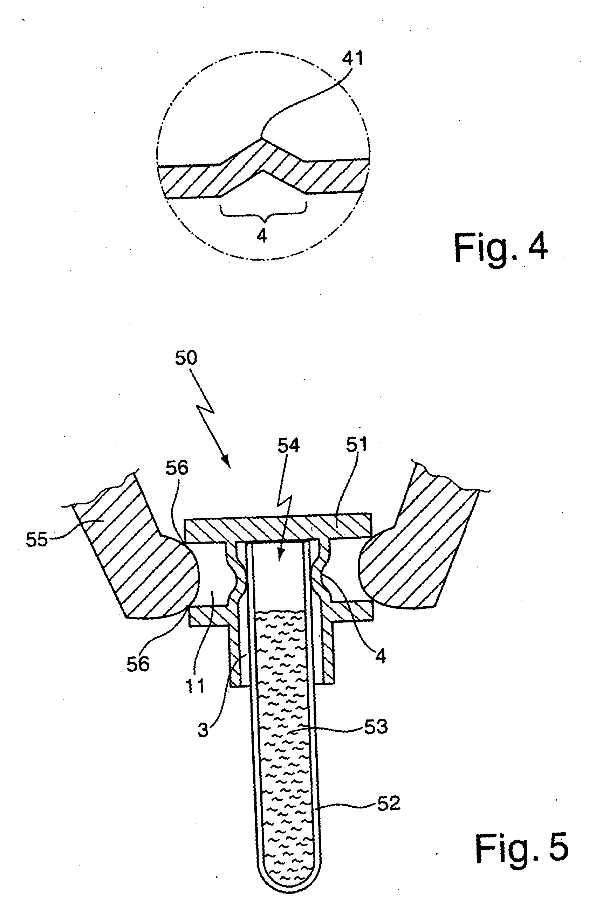

In den Innenraum 3 ist durch die Einführöffnung 2 ein Probenröhrchen (nicht dargestellt, siehe dazu Fig. 5) einführbar, mit seinem offenen Ende voraus. Mit dem offenen Ende kommt im eingeführten Zustand das Probenröhrchen an der Innenkante 7 der Innenbohrung 3 zum Anschlag. Die Außenwände des Probenröhrchens drücken dann die Dichtlippe 4 elastisch geringfügig radial nach außen (entgegen Pfeilrichtung R), so dass die Dichtlippe 4 über den gesamten Außenumfang des Probenröhrchens zur engen und insbesondere gas- und flüssigkeitsdichten Anlage kommt.

Die Kappe 1 weist außerdem einen Zugangskanal 8 auf, durch den das offene Ende eines gehaltenen Probenröhrchens erreichbar ist, und damit auch der Innenraum des Probenröhrchens, etwa zum Einfüllen einer Probe. Alternativ kann die Kappe 1 auch als Verschlusskappe ausgebildet sein, die einen oberen Bereich 9 der Innenbohrung 3, der jenseits der Dichtlippe 4 und abgewandt.von der Einführöffnung 2 gelegen ist, dicht verschließt; in diesem Fall entfällt der Zugangskanal 8 und ist durch Vollmaterial der Kappe ersetzt.

An der Außenkontur der Kappe 1 sind außerdem mehrere umlaufende Nuten 10, 11, 12 ausgebildet. Die äußeren Nuten 10 und 12 dienen der Gewichtsersparnis, während die mittlere Nut 11, an deren Grund auch die Dichtlippe 4 ausgebildet ist, für den Eingriff von Greiferfingern vorgesehen ist (vgl. dazu Fig. 5).

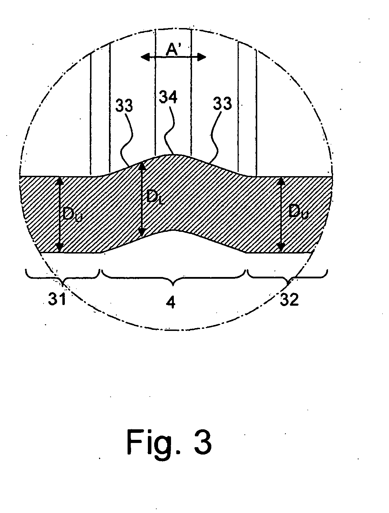

**Figur 3** zeigt einen Detailausschnitt von Fig. 2 im Bereich der Dichtlippe 4. Die Wandstärke D_{L} der Dichtlippe 4 in radialer Richtung ist über die gesamte axiale

Erstreckung der Dichtlippe 4 konstant. In der unmittelbaren Umgebung 31, 32 der Dichtlippe 4 axial oberhalb und unterhalb der Dichtlippe 4 sind die Wandstärken D_{U} identisch zur konstanten Wandstärke D_{L} der Dichtlippe 4. Die axiale Erstreckung der Umgebungen 31, 32 , in der die Wandstärke D_{U} vorliegt, ist gleich oder größer der Wandstärke D_{U}.

Die innere Kontur der Dichtlippe 4 ist näherungsweise symmetrisch und verläuft mit zwei Flanken 33 jeweils schräg zur axialen Richtung A', jedoch näherungsweise in gerader Linie. Am engsten Bereich 34 ist die innere Kontur der Dichtlippe 4 abgerundet.

In einer alternativen Ausführungsform, dargestellt in **Figur 4**, kann auch eine am engsten Bereich 41 an einer Kante spitz zulaufende Dichtlippe 4 vorgesehen sein.

**Figur 5** zeigt eine erfindungsgemäße Probenanordnung 50, umfassend eine erfindungsgemäße Kappe 51 (Hülse) und ein darin gehaltenes Probenröhrchen 52 (Glaskappillar-Probengefäß), im schematischen Querschnitt. Das Probenröhrchen 52 enthält eine flüssige Probe 53 und wurde mit dem offenen Ende 54 voraus in die Innenbohrung 3 der Kappe 51 eingeführt. Die Kappe 51 ist als Verschlusskappe ausgebildet.

Das Probenröhrchen 52 wird allein an einer Dichtlippe 4 geklemmt, wobei die Dichtlippe 4 geringfügig elastisch gespreizt ist. Der Außendurchmesser des Probenröhrchens 52 ist somit geringfügig größer als der kleinste Innendurchmesser der Dichtlippe 4 im entspannten Zustand. Typische Außendurchmesser von Probenröhrchen 52 im Rahmen dieser Erfindung betragen 1 mm bis 5 mm, insbesondere 3mm oder 4mm oder 5mm; die Kappe 51 bzw. deren Dichtlippe 4 ist darauf jeweils abgestimmt.

An einer am äußeren Umfang der Kappe 51 verlaufenden Nut 11 greifen Greiffinger 55 ein, die an zwei Außenkanten 56 der Nut 11 anliegen und so eine sichere Handhabung, insbesondere einen Transport der Probenanordnung 50 mit einem automatischen Probengreifer, zu dem die Greiffinger 55 gehören, gestatten.

## Patentansprüche

1. Kappe (1; 51) für ein NMR-Probenröhrchen (52),
mit einer Innenbohrung (3) für die Aufnahme eines offenen Endes (54) eines NMR-Probenröhrchens (52),
wobei die Innenbohrung (3) eine Wand aufweist, im Wesentlichen kreiszylinderförmig ausgebildet ist und eine Verengung zum Abdichten eines aufgenommenen NMR-Probenröhrchens (52) gegen die Kappe (1; 51) entlang des Außenumfangs des NMR-Probenröhrchens (52) aufweist,
wobei die Verengung als eine über den gesamten Außenumfang umlaufende, innen liegende, elastisch verformbare Dichtlippe (4) ausgebildet ist,
**dadurch gekennzeichnet,**
**dass** im entspannten Zustand der Kappe (1; 51), in welchem kein NMR-Probenröhrchen (52) in die Innenbohrung (3) eingeführt ist, auf der radial außen liegenden Seite der Wand eine Aussparung vorhanden ist, deren Form der radial innen liegenden Seite der Dichtlippe (4) entspricht, so dass die Wand der Kappe (1; 51) im gesamten Bereich der Dichtlippe (4) und in der Umgebung (31, 32) der Dichtlippe (4) eine einheitliche, konstante Wandstärke (D_{L}, D_{U}) aufweist.

2. Kappe (1; 51) nach Anspruch 1, **dadurch gekennzeichnet, dass** die Dichtlippe (4) im entspannten Zustand auf der radial nach innen gewandten Seite einen abgerundeten Querschnitt aufweist.

3. Kappe (1; 51) nach Anspruch 1, **dadurch gekennzeichnet, dass** die Dichtlippe (4) im entspannten Zustand auf der radial nach innen gewandten Seite einen spitz zulaufenden Querschnitt (41) aufweist.

4. Kappe (1; 51) nach einem der Ansprüche 2 oder 3, **dadurch gekennzeichnet, dass** die Kappe (1; 51) im Wesentlichen rotationssymmetrisch aufgebaut ist.

5. Kappe (1; 51) nach einem der vorhergehenden Ansprüche, **dadurch gekennzeichnet, dass** die Innenbohrung (3) einen Kontaktring (5) zum Halten des NMR-Probenröhrchens (52) an dessen Außenumfang aufweist, wobei der Kontaktring (5) von der Dichtlippe (4) verschieden ist.

6. Kappe (1; 51) nach Anspruch 5, **dadurch gekennzeichnet, dass** der Kontaktring (5) näher an einer Einführöffnung (2) für das NMR-Probenröhrchen (52) liegt als die Dichtlippe (4).

7. Kappe (1; 51) nach einem der Ansprüche 5 oder 6, **dadurch gekennzeichnet, dass** der Kontaktring (5) von mehreren, separaten Segmenten (6) gebildet wird.

8. Kappe (1; 51) nach einem der Ansprüche 5 oder 6, **dadurch gekennzeichnet, dass** der Kontaktring (5) als weitere, innen liegende Dichtlippe ausgebildet ist.

9. Kappe (1; 51) nach einem der vorhergehenden Ansprüche, **dadurch gekennzeichnet, dass** die Kappe (1; 51) an ihrem Außenumfang eine Nut (11) für den Eingriff eines Probengreifers aufweist.

10. Kappe (1; 51) nach einem der vorhergehenden Ansprüche, **dadurch gekennzeichnet, dass** die Kappe (1; 51) einen Zugangskanal (8) zur Innenbohrung (3) aufweist, der in einem oberen Bereich (9) jenseits der Dichtlippe (4), der einer Einführöffnung (2) für das NMR-Probenröhrchen (52) abgewandt ist, in der Innenbohrung (3) mündet.

11. Kappe (1; 51) nach einem der Ansprüche 1 bis 9, **dadurch gekennzeichnet, dass** die Kappe (1; 51) die Innenbohrung (3) in einem oberen Bereich (9) jenseits der Dichtlippe (4), der einer Einführöffnung (2) für das NMR-Probenröhrchen (52) abgewandt ist, vollständig verschließt.

12. Kappe (1; 51) nach einem der vorhergehenden Ansprüche, **dadurch gekennzeichnet, dass** die Kappe (1; 51) aus Kunststoff gefertigt ist.

13. NMR-Probenanordnung (50), umfassend eine Kappe (1; 51) und ein NMR-Probenröhrchen (52), auf welches die Kappe (1; 51) aufgesetzt werden kann, **dadurch gekennzeichnet, dass** die Kappe (1; 51) ausgebildet ist gemäß einem der vorhergehenden Ansprüche.

## Claims

1. Cap (1; 51) for an NMR sample tube (52) having an inner bore (3) for receiving an open end (54) of an NMR sample tube (52), wherein the inner bore (3) has a wall, has a substantially circular cylindrical shape, and has a narrowing for sealing a received NMR sample tube (52) against the cap (1; 51) along the outer periphery of the NMR sample tube (52), wherein the narrowing is designed in the form of an inner sealing lip (4) which extends over the entire outer periphery and can be elastically deformed,
**characterized in that**
in a relaxed state of the cap (1; 51) in which no NMR sample tube (52) is inserted into the inner bore (3), a recess is provided on the radially outer side of the wall, the shape of which corresponds to the radially inner side of the sealing lip (4) such that the wall of the cap (1; 51) has a uniform constant wall thickness (D_{L}, D_{U}) in the entire region of the sealing lip (4) and in the vicinity (31, 32) of the sealing lip (4).

2. Cap (1; 51) according to claim 1, **characterized in that**, in a relaxed state, the sealing lip (4) has a rounded cross-section on the radially inwardly facing side.

3. Cap (1; 51) according to claim 1, **characterized in that**, in a relaxed state, the sealing lip (4) has a tapering cross-section (41) on the radially inwardly facing side.

4. Cap (1; 51) according to one of the claims 2 or 3, **characterized in that** the cap (1; 51) is substantially rotationally symmetrical.

5. Cap (1; 51) according to any one of the preceding claims, **characterized in that** the inner bore (3) has a contact ring (5) for holding the NMR sample tube (52) at its outer periphery, wherein the contact ring (5) is different from the sealing lip (4).

6. Cap (1; 51) according to claim 5, **characterized in that** the contact ring (5) is disposed closer to an insertion opening (2) for the NMR sample tube (52) than the sealing lip (4).

7. Cap (1; 51) according to one of the claims 5 or 6, **characterized in that** the contact ring (5) is formed by several separate segments (6).

8. Cap (1; 51) according to one of the claims 5 or 6, **characterized in that** the contact ring (5) is formed as a further inner sealing lip.

9. Cap (1; 51) according to any one of the preceding claims, **characterized in that** the cap (1; 51) has a groove (11) on its outer periphery for engagement of a sample gripper.

10. Cap (1; 51) according to any one of the preceding claims, **characterized in that** the cap (1; 51) has an access channel (8) to the inner bore (3), which opens into the inner bore (3) in an upper area (9) beyond the sealing lip (4) facing away from an insertion opening (2) for the NMR sample tube (52).

11. Cap (1; 51) according to any one of the claims 1 through 9, **characterized in that** the cap (1; 51) completely closes the inner bore (3) in an upper area (9) beyond the sealing lip (4) facing away from an insertion opening (2) for the NMR sample tube (52).

12. Cap (1; 51) according to any one of the preceding claims, **characterized in that** the cap (1; 51) is produced from plastic material.

13. NMR sample configuration (50) comprising a cap (1; 51) and an NMR sample tube (52) onto which the cap (1; 51) can be disposed, **characterized in that** the cap (1; 51) is designed in accordance with any one of the preceding claims.

## Revendications

1. Capuchon (1 ; 51) pour un tube à échantillon RMN (52),
avec un trou intérieur (3) pour la réception d'une extrémité ouverte (54) d'un tube à échantillon RMN (52),
le trou intérieur (3) présentant une paroi, étant de forme essentiellement cylindrique circulaire et présentant un rétrécissement pour assurer l'étanchéité d'un tube à échantillon RMN (52) reçu contre le capuchon (1 ; 51) le long de la circonférence extérieure du tube à échantillon RMN (52),
le rétrécissement étant réalisé sous la forme d'une lèvre d'étanchéité (4) intérieure, déformable élastiquement, faisant tout le tour de la circonférence extérieure,
**caractérisé en ce**
**qu'**à l'état détendu du capuchon (1 ; 51), dans lequel aucun tube à échantillon RMN (52) n'est introduit dans le trou intérieur (3), il existe du côté radialement extérieur de la paroi un évidement dont la forme correspond au côté radialement intérieur de la lèvre d'étanchéité (4), de sorte que la paroi du capuchon (1 ; 51) présente une épaisseur de paroi (D_{L}, D_{U}) homogène constante dans toute la zone de la lèvre d'étanchéité (4) et au voisinage (31, 32) de la lèvre d'étanchéité (4).

2. Capuchon (1 ; 51) selon la revendication 1, **caractérisé en ce que** la lèvre d'étanchéité (4) présente, à l'état détendu, une section arrondie du côté tourné radialement vers l'intérieur.

3. Capuchon (1 ; 51) selon la revendication 1, **caractérisé en ce que** la lèvre d'étanchéité (4) présente, à l'état détendu, une section (41) se terminant en pointe du côté tourné radialement vers l'intérieur.

4. Capuchon (1 ; 51) selon une des revendications 2 ou 3, **caractérisé en ce que** le capuchon (1 ; 51) est essentiellement construit comme un corps à symétrie de révolution.

5. Capuchon (1 ; 51) selon une des revendications précédentes, **caractérisé en ce que** le trou intérieur (3) présente un anneau de contact (5) pour maintenir le tube à échantillon RMN (52) sur sa circonférence extérieure, l'anneau de contact (5) étant différent de la lèvre d'étanchéité (4).

6. Capuchon (1 ; 51) selon la revendication 5, **caractérisé en ce que** l'anneau de contact (5) est situé plus près d'une ouverture d'introduction (2) pour le tube à échantillon RMN (52) que la lèvre d'étanchéité (4).

7. Capuchon (1 ; 51) selon une des revendications 5 ou 6, **caractérisé en ce que** l'anneau de contact (5) est formé de plusieurs segments (6) séparés.

8. Capuchon (1 ; 51) selon une des revendications 5 ou 6, **caractérisé en ce que** l'anneau de contact (5) est réalisé sous la forme d'une autre lèvre d'étanchéité intérieure.

9. Capuchon (1 ; 51) selon une des revendications précédentes, **caractérisé en ce que** le capuchon (1 ; 51) présente sur sa circonférence extérieure une rainure (11) pour l'engagement d'un manipulateur d'échantillons.

10. Capuchon (1 ; 51) selon une des revendications précédentes, **caractérisé en ce que** le capuchon (1 ; 51) présente un canal d'accès (8) vers le trou intérieur (3), qui débouche dans le trou intérieur (3) dans une zone supérieure (9) située au-delà de la lèvre d'étanchéité (4), qui est opposée à une ouverture d'introduction (2) pour le tube à échantillon RMN (52).

11. Capuchon (1 ; 51) selon une des revendications 1 à 9, **caractérisé en ce que** le capuchon (1 ; 51) obture complètement le trou intérieur (3) dans une zone supérieure (9) située au-delà de la lèvre d'étanchéité (4), qui est opposée à une ouverture d'introduction (2) pour le tube à échantillon RMN (52).

12. Capuchon (1 ; 51) selon une des revendications précédentes, **caractérisé en ce que** le capuchon (1 ; 51) est réalisé en matière plastique.

13. Dispositif pour échantillon RMN (50), comprenant un capuchon (1 ; 51) et un tube à échantillon RMN (52) sur lequel le capuchon (1 ; 51) peut être positionné, **caractérisé en ce que** le capuchon (1 ; 51) est réalisé selon une des revendications précédentes.
